# DEMANDE DE BREVET EUROPEEN

(11) **EP 4 383 292 A1**
(43) Date de publication de la demande: **12.06.2024**
(21) Numéro de dépôt: 23206806.4
(22) Date de dépôt: 30.10.2023
(51) Int. Cl.: H01G 4/005, H01G 4/012, H01G 4/30, H01G 4/33, H01L 21/02, H01L 21/64, H01L 21/311, H01L 21/3213, H01G 4/10, H01G 4/12, H01G 4/232

(54) **PROCÉDÉ DE FABRICATION D'UN CONDENSATEUR**

(30) Priorité: 14.11.2022 FR 2211799
(71) Demandeur: STMicroelectronics International N.V., 1228 Plan-les-Ouates, Geneva (CH)
(72) Inventeur: CARO, Vincent, 37170 CHAMBRAY LES TOURS (FR); PAOLI, Quentin, 37100 TOURS (FR)
(74) Mandataire: Cabinet Beaumont

(57) **Abrégé**

La présente description concerne un procédé de fabrication d'un condensateur, comportant les étapes successives suivantes :
a) former un empilement comportant, dans l'ordre à partir de la face supérieure d'une première couche conductrice (13), une première électrode (15), une couche diélectrique (17), une deuxième électrode (19) et une deuxième couche conductrice (23) ;
b) former, par photolithographie, une couche de masquage sur une face de la deuxième couche conductrice à l'opposé de la deuxième électrode ;
c) graver, par gravure plasma physico-chimique chlorée, à travers ladite couche de masquage, une partie supérieure de l'empilement, ladite gravure plasma physico-chimique chlorée étant interrompue dans la couche diélectrique ;
d) graver, par gravure plasma physico-chimique fluorée, à travers ladite couche de masquage, une partie inférieure de l'empilement, ladite gravure plasma physico-chimique fluorée étant interrompue sur la face supérieure de la première couche conductrice ; et
e) retirer la couche de masquage.

## Description

### Domaine technique

La présente description concerne de façon générale la fabrication d'un circuit intégré et vise plus particulièrement la fabrication d'un circuit intégré comportant un condensateur, par exemple un circuit intégré passif, par exemple un filtre RC (comportant une résistance et un condensateur), un filtre LC (comportant une inductance et un condensateur) ou un filtre RLC (comportant une résistance, une inductance et un condensateur).

### Technique antérieure

De nombreux procédés de fabrication de circuits intégrés comportant des condensateurs ont été proposés. Ces procédés présentent divers inconvénients. Il existe alors un besoin d'amélioration des procédés de fabrication d'un circuit intégré comprenant un condensateur pour pallier tout ou partie des inconvénients des procédés connus.

### Résumé de l'invention

Un mode de réalisation prévoit un procédé de fabrication d'un condensateur, comportant les étapes successives suivantes :
a) former un empilement comportant, dans l'ordre à partir de la face supérieure d'une première couche conductrice, une première électrode, une couche diélectrique, une deuxième électrode et une deuxième couche conductrice ;
b) former, par photolithographie, une couche de masquage sur une face de la deuxième couche conductrice à l'opposé de la deuxième électrode ;
c) graver, par gravure plasma physico-chimique chlorée, à travers ladite couche de masquage, une partie supérieure de l'empilement, ladite gravure plasma physico-chimique chlorée étant interrompue dans la couche diélectrique ;
d) graver, par gravure plasma physico-chimique fluorée, à travers ladite couche de masquage, une partie inférieure de l'empilement, ladite gravure plasma physico-chimique fluorée étant interrompue sur la face supérieure de la première couche conductrice ; et
e) retirer la couche de masquage par un procédé de décapage, puis nettoyer les flancs gravés par un procédé de nettoyage.

Selon un mode de réalisation, la première couche conductrice est à base d'aluminium.

Selon un mode de réalisation, la deuxième couche conductrice est à base d'aluminium.

Selon un mode de réalisation, lors de l'étape c), du dichlore et du trichlorure de bore sont injectés dans la source plasma.

Selon un mode de réalisation, lors de l'étape c), le dichlore est injecté avec un débit entre 50 sccm et 120 sccm, par exemple de l'ordre de 80 sccm et le trichlorure de bore est injecté avec un débit compris entre 20 sccm et 100 sccm, par exemple de l'ordre de 50 sccm.

Selon un mode de réalisation, lors de l'étape c), la pression du plasma est comprise entre 10 mTorr et 50 mTorr, par exemple de l'ordre de 15 mTorr, la puissance source est comprise entre 150 W et 800 W, par exemple de l'ordre de 400 W et la puissance de polarisation est comprise entre 50 W et 500 W, par exemple comprise entre 150 W et 300 W.

Selon un mode de réalisation, lors de l'étape d), de l'hexafluorure de soufre et de l'argon sont injectés dans la source plasma.

Selon un mode de réalisation, lors de l'étape d), l'hexafluorure de soufre est injecté avec un débit compris entre 20 sccm et 80 sccm, par exemple de l'ordre de 50 sccm et l'argon est injecté avec un débit compris entre 10 sccm et 100 sccm, par exemple de l'ordre de 20 sccm.

Selon un mode de réalisation, lors de l'étape c), la pression du plasma est comprise entre 5 mTorr et 50 mTorr, par exemple de l'ordre de 10 mTorr, la puissance source est comprise entre 150 W et 800 W, par exemple de l'ordre de 500 W et la puissance de polarisation est comprise entre 20 W et 500 W, par exemple de l'ordre de 50 W.

Selon un mode de réalisation, à l'étape e), l'étape de nettoyage comprend le nettoyage de la face supérieure et des flancs de la deuxième couche conductrice, des flancs de la deuxième électrode, de la couche diélectrique, de la première électrode et de la face supérieure de la première couche conductrice.

Selon un mode de réalisation, l'étape de décapage est réalisée par gravure physico-chimique plasma.

Selon un mode de réalisation, lors de l'étape de décapage, du dioxygène et de la vapeur d'eau sont injectés dans la source plasma.

Selon un mode de réalisation, lors de l'étape de décapage, le dioxygène est injecté avec un débit compris entre 700 sccm et 1000 sccm, par exemple de l'ordre de 810 sccm et de la vapeur d'eau est injectée avec un débit compris entre 50 sccm et 700 sccm, par exemple de l'ordre de 90 sccm ou de l'ordre de 630 sccm.

Selon un mode de réalisation, lors de l'étape de décapage, la pression du plasma est comprise entre 600 mTorr et 1000 mTorr, par exemple comprise entre 750 mTorr et 900 mTorr et la puissance RF est comprise entre 800 W et 1500 W, par exemple de l'ordre de 1100 W.

Selon un mode de réalisation, l'étape de nettoyage est réalisée à l'aide d'un solvant à base de 2-(2-aminoéthoxy)éthanol et d'hydroxylamine.

Selon un mode de réalisation, la proportion de 2-(2-aminoéthoxy)éthanol dans le solvant est comprise entre 55 % et 65 % et la proportion d'hydroxylamine est comprise entre 10 % et 20 %.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un condensateur ; et
la figure 2, la figure 3, la figure 4 et la figure 5 illustrent des étapes successives d'un exemple d'un procédé de formation d'un condensateur selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on s'intéresse ici principalement à la formation d'une portion de circuit intégré formant le condensateur. Plus particulièrement, on s'intéresse ici principalement à une étape de gravure permettant de découvrir une couche métallique en vue de reprendre un contact électrique sur une électrode inférieure d'un condensateur du circuit intégré. Les autres étapes du procédé de fabrication du condensateur et du circuit intégré sont à la portée de la personne du métier et ne seront pas décrites ci-après.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

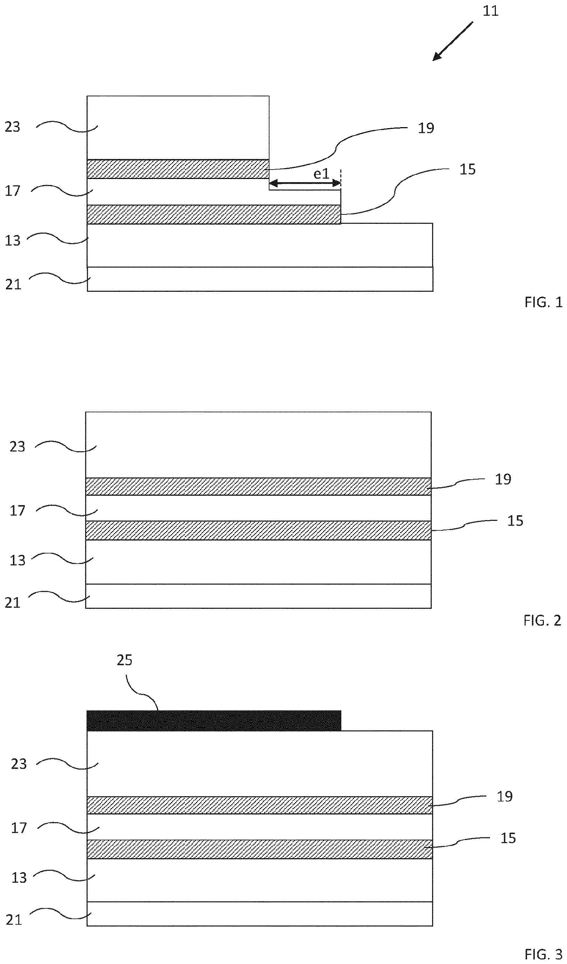

la figure 1 est une vue en coupe, partielle et schématique, d'un exemple d'un condensateur 11.

Le condensateur 11 comprend, dans l'ordre, à partir de la face supérieure d'un substrat ou support 21 :
une première couche électriquement conductrice 13, aussi appelée couche de redistribution (RDL, redistribution layer) ;
une première électrode 15 aussi appelée électrode inférieure ;
une couche 17 en un matériau diélectrique ;
une deuxième électrode 19 aussi appelée électrode supérieure ; et
une deuxième couche électriquement conductrice 23.

A titre d'exemple, l'électrode inférieure 15 est en contact, par sa face inférieure, avec la face supérieure de la couche 13. La couche diélectrique 17 est, par exemple, en contact, par sa face inférieure, avec la face supérieure de l'électrode inférieure 15. L'électrode supérieure 19 est, par exemple, en contact, par sa face inférieure, avec la face supérieure de la couche diélectrique 17. La couche conductrice 23 est, par exemple, en contact, par sa face inférieure, avec la face supérieure de l'électrode supérieure 19.

A titre d'exemple, la couche conductrice 13 est en un matériau métallique. La couche conductrice 13 est, par exemple, en aluminium ou en un alliage comprenant de l'aluminium. La couche conductrice 13 est, par exemple, en un alliage d'aluminium et de cuivre (AlCu) ou un alliage d'aluminium, de cuivre et de silicium (AlSiCu). A titre d'exemple, la couche 13 a une épaisseur comprise entre 0,5 µm et 3 µm, par exemple de l'ordre de 1,5 pm.

L'électrode 15 est, par exemple, en nitrure de tantale (TaN). A titre d'exemple, l'électrode 15 a une épaisseur comprise entre 20 nm et 200 nm, par exemple de l'ordre de 65 nm. L'électrode 19 est, par exemple, en nitrure de tantale (TaN). A titre d'exemple, l'électrode 19 a une épaisseur comprise entre 20 nm et 200 nm, par exemple de l'ordre de 65 nm. Les électrodes 15 et 19 sont par exemple en le même matériau.

La couche diélectrique 17 est par exemple en nitrure de silicium. A titre d'exemple, la couche diélectrique 17 a une épaisseur comprise entre 20 nm et 600 nm, par exemple comprise entre 100 nm et 450 nm.

Le support 21 est, par exemple, en silicium, de préférence fortement résistif. Le support 21 et la couche 13 peuvent être séparés l'un de l'autre par une couche diélectrique, non représentée, par exemple une couche d'oxyde, par exemple du verre de silicium non dopé (USG, Undoped Silicon Glass) ou tout autre oxyde de silicium. A titre de variante, la couche conductrice inférieure 13 est en contact, par sa face inférieure, avec la face supérieure du substrat 21. Le support 21 porte par exemple un ou plusieurs autres éléments, non représentés, tels que des inductances ou des résistances formées à proximité du condensateur et connectés électriquement au condensateur.

A titre d'exemple, la couche conductrice 23 est en un matériau métallique. La couche conductrice 23 est, par exemple, en un matériau métallique pouvant être gravé par plasma, par exemple par plasma chloré. A titre d'exemple, la couche conductrice 23 est en aluminium ou en un alliage à base d'aluminium. La couche conductrice 23 a, par exemple, une épaisseur comprise entre 100 nm et 1 µm, par exemple, de l'ordre de 350 nm. La couche 23 permet notamment d'augmenter la conductivité électrique de l'électrode supérieure 19 qu'elle recouvre.

Dans l'exemple de la figure 1, la couche conductrice 23, l'électrode 19 et la partie supérieure de la couche diélectrique 17 ont leurs flancs en retrait par rapport à ceux de l'électrode 15 et de la partie inférieure de la couche diélectrique 17. Autrement dit, une portion de la partie inférieure de la couche diélectrique 17 n'est pas recouverte par la partie supérieure de la couche diélectrique 17, l'électrode supérieure 19 et la couche conductrice 23. Ainsi, en figure 1, il existe une première marche entre la face supérieure de la couche conductrice supérieure 23 et la face supérieure de la couche diélectrique 17. Cette marche permet d'introduire une distance horizontale e1 entre le flanc des couches 23 et 19 et de la partie supérieure de la couche 17 d'une part, et le flanc de la partie inférieure de la couche 17 et de l'électrode 15 d'autre part, réduisant ainsi les risques de court-circuit.

A titre d'exemple, la couche conductrice 23, l'électrode 19 et une partie supérieure de la couche diélectrique 17 sont, en figure 1, alignées verticalement, c'est-à-dire qu'elles ont leurs flancs alignés. Similairement, l'électrode 15 et une partie inférieure de la couche diélectrique 17 sont, par exemple, alignées verticalement.

Dans l'exemple de la figure 1, les électrodes 15 et 19 et les couches 23 et 17 sont en retrait par rapport à la couche conductrice 13. Autrement dit, une portion de la face supérieure de la couche conductrice 13 n'est pas recouverte par les électrodes 15 et 19 et les couches 23 et 17. Ainsi, en figure 1, il existe une deuxième marche entre la face supérieure de la couche diélectrique 17 et la face supérieure de la couche conductrice inférieure 13. Ceci permet, lors d'une étape de fabrication non détaillée, la reprise d'un contact électrique sur l'électrode inférieure 15 du condensateur, par l'intermédiaire de la couche conductrice 13, par exemple, au moyen d'un fil métallique soudé à la face supérieure de la portion exposée de la couche 13.

A titre d'exemple, pour former la structure illustrée en figure 1, on dépose d'abord successivement la couche 13, l'électrode 15, la couche 17, l'électrode 19 et la couche 23 sur le substrat 21. A ce stade, la couche 13, l'électrode 15, la couche 17, l'électrode 19 et la couche 23 s'étendent chacune de façon continue et avec une épaisseur sensiblement uniforme sur la face supérieure du substrat 21. Lors d'une première étape de photolithographie et gravure, on vient alors retirer localement la couche 23, l'électrode 19, et la partie supérieure de la couche diélectrique 17, de façon à former la première marche. Lors d'une deuxième étape de photolithographie et gravure, on vient ensuite retirer localement, en vis à vis d'une partie de la surface de la couche diélectrique 17 exposée à l'issue de la première étape, la partie inférieure de la couche diélectrique 17 et l'électrode inférieure 15, de façon à former la deuxième marche.

A titre d'exemple, les deux étapes de gravures sont des gravures plasma physico-chimiques mises en oeuvre au moyen de plasmas de compositions différentes.

La gravure de l'empilement en deux temps permet la gravure des couches 23 et 17 et des électrodes 15 et 19 sans que la couche 13 ne soit gravée. Les couches 23 et 13 étant toutes deux, par exemple, à base d'aluminium, la partie supérieure de l'empilement (par exemple au moins la couche 23) est gravée à l'aide d'une gravure non sélective vis-à-vis de l'aluminium et la partie inférieure de l'empilement (par exemple au moins l'électrode 15) est gravée à l'aide d'une gravure sélective vis-à-vis de l'aluminium. La couche conductrice 23, l'électrode 19 et la partie supérieure de la couche diélectrique 17 sont, par exemple gravées par une gravure physico-chimique à plasma chloré. L'électrode 15 et la partie inférieure de la couche diélectrique 17 sont par exemple gravées par une gravure physico-chimique à plasma fluoré.

La gravure physico-chimique à plasma chloré engendre toutefois, lors de la gravure de la couche 23, la création de résidus à base d'aluminium qui se déposent sur les flancs de la zone gravée. Ces résidus sont, par exemple, conducteurs et peuvent induire un risque de court-circuit ou de claquage du condensateur. Les première et deuxième marches formées respectivement entre la face supérieure de la couche 23 et la face supérieure de la couche 17 et entre la face supérieure de la couche 17 et la face supérieure de la couche 13 visent à réduire ce risque. En effet, ces marches permettent d'introduire une distance horizontale e1 entre le flanc des couches 23et 19 et de la partie supérieure de la couche 17 d'une part, et le flanc de la partie inférieure de la couche 17 et de l'électrode 15 d'autre part, réduisant les risques de dysfonctionnement, comme un court-circuit, liés à la présence des résidus générés lors de la première étape de gravure.

Une limitation de la structure de la figure 1 est que sa fabrication implique deux étapes de photolithographie pour former respectivement les première et deuxième marches. Il en résulte un coût de fabrication relativement élevé.

La figure 2, la figure 3, la figure 4 et la figure 5 illustrent des étapes successives d'un exemple d'un procédé de formation d'un condensateur selon un autre mode de réalisation.

La figure 2 illustre un empilement de départ comportant, successivement, à partir d'une face supérieure du substrat 21, la première couche conductrice 13, la première électrode 15, la couche diélectrique 17, la deuxième électrode 19 et la deuxième couche conductrice 23.

Les couches 13, 17 et 23 et les électrodes 15 et 19 sont similaires aux couches 13, 17 et 23 et électrodes 15 et 19 décrites en relation avec la figure 1. De plus ces couches et électrodes sont arrangées similairement à ce qui a été décrit en relation avec la figure 1 à la différence près que les couches 13, 17 et 23 et les électrodes 15 et 19 sont, à ce stade, alignées. En particulier, les électrodes 15 et 19 et les couches 13, 17, 23 s'étendent chacune au-dessus de toute la surface supérieure du substrat 21.

La figure 3 illustre une structure obtenue à l'issue d'une étape de formation d'une couche de masquage 25 sur la face supérieure de la structure illustrée en figure 2. A titre d'exemple, la couche de masquage 25 est formée par photolithographie.

Pour cela, la couche de masquage 25 est, par exemple, dans un premier temps formée pleine plaque sur la face supérieure de la couche 23, et par exemple en contact avec celle-ci. La couche de masquage 25 est, dans un second temps, par exemple, exposée localement à un rayonnement lumineux, par exemple un rayonnement ultraviolet (UV), au travers d'un masque de photolithographie. Après développement et rinçage, la couche 25 est conservée en vis-à-vis d'une partie de l'empilement où sera formé le condensateur et retirée tout autour.

La couche de masquage 25 est par exemple en une résine, par exemple en une résine photosensible.

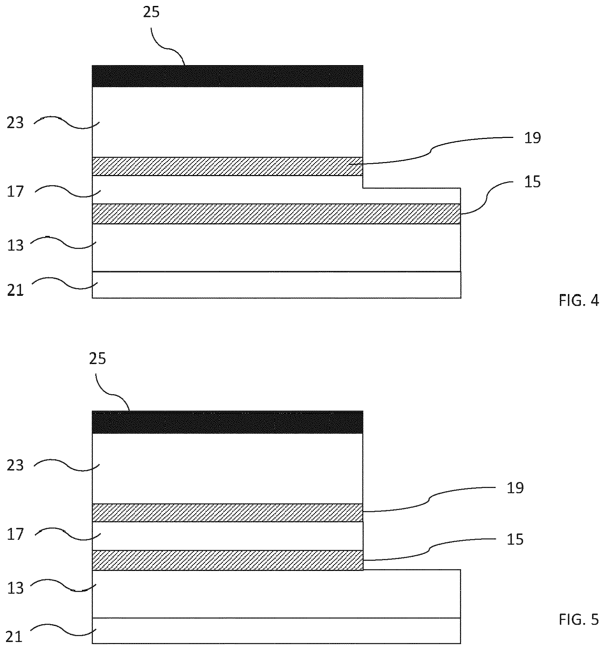

La figure 4 illustre une structure obtenue à l'issue d'une première étape de gravure d'une partie supérieure de l'empilement de la structure illustrée en figure 3.

Lors de cette étape, on vient plus précisément graver, par gravure physico-chimique à plasma chloré, à travers la couche de masquage 25, une partie supérieure de l'empilement des couches 23, 19, 17 et 15. Encore plus précisément, lors de cette étape, on vient graver la couche conductrice 23, l'électrode 19 et une partie supérieure de la couche diélectrique 17 à travers la couche de masquage 25. A titre d'exemple, lors de cette étape, la couche conductrice 23, l'électrode 19 et une partie supérieure de la couche 17 sont retirées hors du vis-à-vis de la couche de masquage 25.

Lors de cette étape, la gravure physico-chimique à plasma chloré est interrompue dans la couche diélectrique 17.

La gravure physico-chimique à plasma chloré est, par exemple, une gravure anisotrope verticale. C'est-à-dire qu'elle est directive et qu'elle s'effectue principalement dans une unique direction préférentielle, ici la direction verticale dans l'orientation de la figure 4 (c'est à dire une direction perpendiculaire à la face supérieure du substrat 21) .

A titre d'exemple, l'étape de gravure est réalisée au moyen d'un plasma dont la pression est, par exemple comprise entre 5 mTorr et 100 mTorr, par exemple comprise entre 10 mTorr et 50 mTorr, par exemple de l'ordre de 15 mTorr. Lors de cette étape, la puissance source est par exemple comprise entre 100 W et 1800 W, par exemple comprise entre 150 W et 800 W, par exemple de l'ordre de 400 W. Lors de cette étape, la puissance de polarisation est par exemple comprise entre 20 W et 1000 W, par exemple comprise entre 50 W et 500 W, par exemple comprise entre 150 W et 300 W. Lors de cette étape du dichlore (Cl₂) est par exemple injecté dans la source plasma. Le débit du dichlore est par exemple compris entre 10 sccm (ou cm³.min⁻¹ à 0 °C et sous pression atmosphérique) et 500 sccm, par exemple compris entre 50 sccm et 120 sccm, par exemple de l'ordre de 80 sccm. Lors de cette étape, du trichlorure de bore (BCl₃) est par exemple injecté dans la source plasma. A titre d'exemple, lors de cette étape, le débit du trichlorure de bore est compris entre 10 sccm et 500 sccm, par exemple compris entre 20 sccm et 100 sccm, par exemple de l'ordre de 50 sccm. Lors de cette étape, du trichlorure de bore et du dichlore sont par exemple injectés dans la source plasma. Lors de cette étape, du trichlorure de bore et du dichlore sont par exemple injectés dans la source plasma, par exemple dans les débits susmentionnés. A titre d'exemple, lors de cette étape, la température de l'électrode inférieure est comprise entre 20 °C et 100 °C, par exemple comprise entre 30 °C et 70 °C, par exemple de l'ordre de 50 °C. A titre d'exemple, lors de cette étape, la température de l'électrode supérieure est comprise entre 20 °C et 100 °C, par exemple comprise entre 50 °C et 90 °C, par exemple de l'ordre de 70 °C.

La figure 5 illustre une structure obtenue à l'issue d'une deuxième étape de gravure d'une partie inférieure de l'empilement de la structure illustrée en figure 4.

La couche de masquage 25 n'est pas retirée à l'issue de l'étape de gravure physico-chimique à plasma chloré décrite en relation avec la figure 4, elle est en effet conservée lors de l'étape de gravure physico-chimique à plasma fluoré décrite en relation avec la figure 5. Les deux étapes de gravure physico-chimique sont donc réalisées à travers la même couche de masquage 25.

Lors de cette étape, on vient plus précisément, graver, par gravure physico-chimique à plasma fluoré, à travers la couche de masquage 25, une partie inférieure de l'empilement des couches 23, 19, 17 et 15. Encore plus précisément, lors de cette étape, on vient graver une partie inférieure de la couche diélectrique 17 et l'électrode 15 à travers la couche de masquage 25. A titre d'exemple, lors de cette étape, la partie inférieure de la couche diélectrique 17 et l'électrode 15 sont retirées hors du vis-à-vis de la couche de masquage 25.

La gravure physico-chimique à plasma fluoré, présente l'avantage de graver la partie inférieure de la couche diélectrique 17 et l'électrode 15 de façon sélective par rapport à la couche 13, contenant par exemple de l'aluminium. Lors de cette étape, la gravure physico-chimique à plasma fluoré s'interrompt donc sur la face supérieure de la couche 13 sans que celle-ci ne soit gravée.

La gravure physico-chimique à plasma fluoré est, par exemple, une gravure anisotrope verticale. C'est-à-dire qu'elle est directive et qu'elle s'effectue principalement dans une unique direction préférentielle, ici la direction verticale dans l'orientation de la figure 5.

A titre d'exemple, l'étape de gravure est réalisée au moyen d'un plasma dont la pression est, par exemple comprise entre 5 mTorr et 100 mTorr, par exemple comprise entre 5 mTorr et 50 mTorr, par exemple de l'ordre de 10 mTorr. Lors de cette étape, la puissance source est par exemple comprise entre 100 W et 1800 W, par exemple comprise entre 150 W et 800 W, par exemple de l'ordre de 500 W. Lors de cette étape, la puissance de polarisation est par exemple comprise entre 20 W et 1000 W, par exemple comprise entre 20 W et 500 W, par exemple de l'ordre de 50 W. Lors de cette étape de l'hexafluorure de soufre (SF₆) est par exemple injecté dans la source plasma. Le débit de l'hexafluorure de soufre est par exemple compris entre 10 sccm (ou cm³.min⁻¹ à 0 °C et sous pression atmosphérique) et 500 sccm, par exemple compris entre 20 sccm et 80 sccm, par exemple de l'ordre de 50 sccm. Lors de cette étape, de l'argon (Ar) est par exemple injecté dans la source plasma. A titre d'exemple, lors de cette étape, le débit de l'argon est compris entre 10 sccm et 500 sccm, par exemple compris entre 10 sccm et 100 sccm, par exemple de l'ordre de 20 sccm. Lors de cette étape, de l'hexafluorure de soufre et de l'argon sont par exemple injectés dans la source plasma. A titre d'exemple, lors de cette étape, de l'hexafluorure de soufre et de l'argon sont par exemple injectés dans la source plasma dans les débits susmentionnés. A titre d'exemple, lors de cette étape, la température de l'électrode inférieure est comprise entre 20 °C et 100 °C, par exemple comprise entre 30 °C et 70 °C, par exemple de l'ordre de 50 °C. A titre d'exemple, lors de cette étape, la température de l'électrode supérieure est comprise entre 20 °C et 100 °C, par exemple comprise entre 50 °C et 90 °C, par exemple de l'ordre de 70 °C.

A titre d'exemple, les deux étapes de gravure physico-chimique à plasma chloré et fluoré sont mises en oeuvre dans deux équipements de gravure du même type.

La couche de masquage 25 est retirée à l'issue de l'étape de gravure de la partie inférieure de la couche diélectrique 17 et de l'électrode 15 par plasma fluoré.

La couche de masquage 25 est, par exemple, retirée lors d'une étape de décapage ("stripping" en anglais). Cette étape correspond par exemple à une gravure physico-chimique à plasma post-décharge ("downstream" en anglais). A titre d'exemple, cette étape est réalisée dans le même équipement de gravure que l'étape de gravure physico-chimique à plasma chloré (figure 4) et/ou l'étape de gravure à plasma fluoré (figure 5). A titre d'exemple, l'étape de décapage de la couche de masquage 25 est réalisée sous une pression, par exemple comprise entre 300 mTorr et 1200 mTorr, par exemple comprise entre 600 mTorr et 1000 mTorr, par exemple comprise entre 750 mTorr et 900 mTorr. Lors de cette étape, la puissance RF est par exemple comprise entre 600 W et 1800 W, par exemple comprise entre 800 W et 1500 W, par exemple de l'ordre de 1100 W. Lors de cette étape du dioxygène (O₂) est par exemple injecté dans la source plasma. Le débit de dioxygène est par exemple compris entre 500 sccm et 1200 sccm, par exemple compris entre 700 sccm et 1000 sccm, par exemple de l'ordre de 810 sccm. Lors de cette étape de la vapeur d'eau (H₂O) est par exemple injecté dans la source plasma. Le débit de vapeur d'eau est, par exemple compris entre 10 sccm et 1000 sccm, par exemple compris entre 50 sccm et 700 sccm, par exemple de l'ordre de 90 sccm ou de l'ordre de 630 sccm. A titre d'exemple, lors de cette étape de la vapeur d'eau et du dioxygène sont injectés dans la source plasma. A titre d'exemple, lors de cette étape de la vapeur d'eau et du dioxygène sont injectés dans la source plasma dans les débits susmentionnés. A titre d'exemple, l'étape de décapage a une durée comprise entre 1 sec et 150 sec, par exemple comprise entre 2 secondes et 120 secondes, par exemple comprise entre 5 secondes et 90 secondes.

La face supérieure de la couche conductrice 23, la face supérieure de la couche 13 et les flancs des couches 23, 17 et 13 et des électrodes 19 et 15 sont, par exemple, à la suite de l'étape de décapage, nettoyés. Cette étape permet, par exemple, de retirer les résidus par exemple polymériques issus de la couche de masquage 25 et présents à la surface de la couche conductrice 23. A titre d'exemple, cette étape permet en outre de retirer les résidus de gravure des couches 23 et 17 et des électrodes 19 et 15 formés sur les flancs de ces mêmes couches et électrodes. Cette étape est par exemple réalisée à l'aide d'un solvant.

A titre d'exemple, cette étape est réalisée à l'aide d'un solvant à base de 2-(2-aminoéthoxy)éthanol et d'hydroxylamine. A titre d'exemple, cette étape est réalisée à l'aide d'un solvant à base de 2-(2-aminoéthoxy)éthanol, d'hydroxylamine, de pyrocatéchol et d'hydroquinone.

A titre d'exemple, cette étape est réalisée à l'aide d'un solvant à base de 2-(2-aminoéthoxy)éthanol dans une proportion par exemple comprise entre 35 % et 80%, par exemple comprise entre 55 % et 65 % et d'hydroxylamine dans une proportion par exemple comprise entre 2 % et 35 %, par exemple comprise entre 10 % et 20 %. A titre d'exemple, cette étape est réalisée à l'aide d'un solvant à base de 2-(2-aminoéthoxy)éthanol dans une proportion par exemple comprise entre 35 % et 80%, par exemple comprise entre 55 % et 65 %, d'hydroxylamine dans une proportion par exemple comprise entre 2 % et 35 %, par exemple comprise entre 10 % et 20 %, de pyrocatéchol dans une proportion par exemple comprise entre 1 % et 20 %, par exemple comprise entre 3 % et 10 % et d'hydroquinone dans une proportion par exemple comprise entre 0,001 % et 1 %, par exemple comprise entre 0,01 % et 0,1 %.

A titre d'exemple, cette étape est réalisée à l'aide d'un solvant du type commercialisé sous la référence EKC265 par la société Dupont.

A l'issu du procédé décrit en relation avec les figures 3 à 5, les couches 17 et 23 et les électrodes 15 et 19 ont leurs flancs sensiblement alignés verticalement.

On notera toutefois que, selon les matériaux utilisés, la vitesse de gravure des électrodes 15 et 19 peut être légèrement supérieure à celle des couches 17 et 23. Dans ce cas, à l'issue des étapes de gravure, les flancs des électrodes 15 et 19 peuvent présenter un retrait par rapport au flanc des couches 17 et 23.

A l'issue du procédé décrit en relation avec les figures 2 à 5, un plot métallique, non représenté, par exemple en cuivre, est par exemple disposé sur et en contact avec la face supérieure de la couche conductrice 23.

Un avantage du présent mode de réalisation est lié au choix des recettes de gravure, au mode de décapage et au choix du nettoyage qui permettent de limiter la formation de résidus conducteurs sur les flancs de la zone gravée.

On peut ainsi se passer de la formation des marches (distance de garde e1) décrites en relation avec la figure 1.

Un avantage est que ceci permet de réduire le nombre d'étapes et ainsi le coût de fabrication d'un condensateur en comparaison avec un procédé du type décrit en relation avec la figure 1. En particulier, le procédé décrit en relation avec les figures 2 à 5 comprend une unique étape de photolithographie (un seul masque de photolithographie), contre deux dans le procédé décrit en relation avec la figure 1.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que la gravure physico-chimique à plasma chloré ait été décrite comme s'interrompant dans la couche 17, la gravure physico-chimique peut être interrompue sur la face supérieure de la couche diélectrique 17.

Enfin, la mise en oeuvre pratique des modes de réalisation et variantes décrits est à la portée de la personne du métier à partir des indications fonctionnelles données ci-dessus.

## Revendications

1. Procédé de fabrication d'un condensateur, comportant les étapes successives suivantes :
a) former un empilement comportant, dans l'ordre à partir de la face supérieure d'une première couche conductrice (13), une première électrode (15), une couche diélectrique (17), une deuxième électrode (19) et une deuxième couche conductrice (23) ;
b) former, par photolithographie, une couche de masquage (25) sur une face de la deuxième couche conductrice (23) à l'opposé de la deuxième électrode (19) ;
c) graver, par gravure plasma physico-chimique chlorée, à travers ladite couche de masquage, une partie supérieure de l'empilement, ladite gravure plasma physico-chimique chlorée étant interrompue dans la couche diélectrique (17) ;
d) graver, par gravure plasma physico-chimique fluorée, à travers ladite couche de masquage, une partie inférieure de l'empilement, ladite gravure plasma physico-chimique fluorée étant interrompue sur la face supérieure de la première couche conductrice (13) ; et
e) retirer la couche de masquage (25) par un procédé de décapage, puis nettoyer les flancs gravés par un procédé de nettoyage.

2. Procédé selon la revendication 1, dans lequel la première couche conductrice (13) est à base d'aluminium.

3. Procédé selon la revendication 1 ou 2, dans lequel la deuxième couche conductrice (23) est à base d'aluminium.

4. Procédé selon l'une quelconque des revendications 1 à 3, dans lequel lors de l'étape c), du dichlore et du trichlorure de bore sont injectés dans la source plasma.

5. Procédé selon la revendication 4, dans lequel lors de l'étape c), le dichlore est injecté avec un débit entre 50 sccm et 120 sccm, par exemple de l'ordre de 80 sccm et le trichlorure de bore est injecté avec un débit compris entre 20 sccm et 100 sccm, par exemple de l'ordre de 50 sccm.

6. Procédé selon l'une quelconque des revendications 1 à 5, dans lequel, lors de l'étape c), la pression du plasma est comprise entre 10 mTorr et 50 mTorr, par exemple de l'ordre de 15 mTorr, la puissance source est comprise entre 150 W et 800 W, par exemple de l'ordre de 400 W et la puissance de polarisation est comprise entre 50 W et 500 W, par exemple comprise entre 150 W et 300 W.

7. Procédé selon l'une quelconque des revendications 1 à 6, dans lequel lors de l'étape d), de l'hexafluorure de soufre et de l'argon sont injectés dans la source plasma.

8. Procédé selon la revendication 7, dans lequel lors de l'étape d), l'hexafluorure de soufre est injecté avec un débit compris entre 20 sccm et 80 sccm, par exemple de l'ordre de 50 sccm et l'argon est injecté avec un débit compris entre 10 sccm et 100 sccm, par exemple de l'ordre de 20 sccm.

9. Procédé selon l'une quelconque des revendications 1 à 8, dans lequel, lors de l'étape c), la pression du plasma est comprise entre 5 mTorr et 50 mTorr, par exemple de l'ordre de 10 mTorr, la puissance source est comprise entre 150 W et 800 W, par exemple de l'ordre de 500 W et la puissance de polarisation est comprise entre 20 W et 500 W, par exemple de l'ordre de 50 W.

10. Procédé selon l'une quelconque des revendications 1 à 9, dans lequel à l'étape e), l'étape de nettoyage comprend le nettoyage de la face supérieure et des flancs de la deuxième couche conductrice (23), des flancs de la deuxième électrode (19), de la couche diélectrique (17), de la première électrode (15) et de la face supérieure de la première couche conductrice (13).

11. Procédé selon la revendication 10, dans lequel l'étape de décapage est réalisée par gravure physico-chimique plasma.

12. Procédé selon la revendication 11, dans lequel lors de l'étape de décapage, du dioxygène et de la vapeur d'eau sont injectés dans la source plasma.

13. Procédé selon la revendication 12, dans lequel lors de l'étape de décapage, le dioxygène est injecté avec un débit compris entre 700 sccm et 1000 sccm, par exemple de l'ordre de 810 sccm et de la vapeur d'eau est injectée avec un débit compris entre 50 sccm et 700 sccm, par exemple de l'ordre de 90 sccm ou de l'ordre de 630 sccm.

14. Procédé selon l'une quelconque des revendications 11 à 13, dans lequel lors de l'étape de décapage, la pression du plasma est comprise entre 600 mTorr et 1000 mTorr, par exemple comprise entre 750 mTorr et 900 mTorr et la puissance RF est comprise entre 800 W et 1500 W, par exemple de l'ordre de 1100 W.

15. Procédé selon l'une quelconque des revendications 10 à 14, dans lequel l'étape de nettoyage est réalisée à l'aide d'un solvant à base de 2-(2-aminoéthoxy)éthanol et d'hydroxylamine.

16. Procédé selon la revendication 15, dans lequel la proportion de 2-(2-aminoéthoxy)éthanol dans le solvant est comprise entre 55 % et 65 % et la proportion d'hydroxylamine est comprise entre 10 % et 20 %.
